(19) Europäisches Patentamt
European Patent Office
Office européen des brevets

(11) EP 1 997 843 A1

(12) EUROPEAN PATENT APPLICATION
published in accordance with Art. 158(3) EPC

(43) Date of publication:
03.12.2008 Bulletin 2008/49

(21) Application number: 07738391.7

(22) Date of filing: 13.03.2007

(51) Int Cl.:
*C08G 59/42* (2006.01) *C08K 3/00* (2006.01)
*C08L 63/00* (2006.01) *C08L 75/04* (2006.01)
*H05K 3/28* (2006.01)

(86) International application number:
PCT/JP2007/054919

(87) International publication number:
WO 2007/105713 (20.09.2007 Gazette 2007/38)

(84) Designated Contracting States:
AT BE BG CH CY CZ DE DK EE ES FI FR GB GR HU IE IS IT LI LT LU LV MC MT NL PL PT RO SE SI SK TR

(30) Priority: 16.03.2006 JP 2006072732

(71) Applicant: Showa Denko K.K.
Tokyo 105-8518 (JP)

(72) Inventors:
- ISHIHARA, Yoshimitsu
Kawasaki-shi, Kanagawa 210-0867 (JP)
- INOUE, Hirofumi
Kawasaki-shi, Kanagawa 210-0867 (JP)
- ONISHI, Mina
Kawasaki-shi, Kanagawa 210-0867 (JP)

(74) Representative: Strehl Schübel-Hopf & Partner
Maximilianstrasse 54
80538 München (DE)

# (54) HEAT CURABLE RESIN COMPOSITION, OVERCOATING AGENT FOR FLEXIBLE CIRCUIT BOARD, AND SURFACE PROTECTIVE FILM

(57) Overcoating agents and thermosetting resin compositions of the invention give protective layers that have excellent adhesion to substrates and in particular to tin, excellent long-term reliability of electric insulation and small warpage. A thermosetting resin composition according to the invention includes a carboxyl group-containing urethane resin (A), a curing agent (B) and an acid anhydride (C) as essential components. A flexible circuit board overcoating agent includes the thermosetting resin composition. A surface protective layer of the invention comprises a cured product of the thermosetting resin composition.

EP 1 997 843 A1

## Description

### FIELD OF THE INVENTION

The present invention relates to thermosetting resin compositions giving cured products with good adhesion, and to uses of the compositions. In particular, the invention relates to thermosetting resin compositions that give cured products upon heating which show excellent adhesion to a wiring pattern of a wiring board whereby a flexible circuit board is manufactured which maintains excellent electric insulating properties for a long term. The invention also relates to flexible circuit board overcoating agents containing the thermosetting resin compositions, and surface protective layers that are cured products of the overcoating agents.

### BACKGROUND OF THE INVENTION

Circuits of flexible circuit boards are surface protected by adhesive-bonding a polyimide film called a coverlay film that is punched out to a mold corresponding to the shape of the circuit pattern, or by applying a flexible UV-curable or thermosetting overcoating agent by screen printing. The latter method is advantageous in workability.

Representative curable overcoating agents are epoxy resin-based resin compositions (for example, JP-A-2006-36801 (Patent Document 1)), acrylic resin-based resin compositions, and composite resin compositions of these compositions.

These resin compositions are frequently based on resins that are modified by the introduction of butadiene skeletons, siloxane skeletons, polycarbonate diol skeletons or long-chain aliphatic skeletons. The modification has enabled the surface protective layers to show improved flexibility and be resistant to warpage due to cure shrinkage while their inherent properties such as heat resistance, chemical resistance and electric insulating properties are not substantially deteriorated.

However, the recent weight reduction and downsizing of electronics have required that flexible boards be more lightweight and thinner. As a result, the circuit boards are more noticeably affected by the flexibility and cure shrinkage of the overcoating resin compositions. In more detail, flexible boards are greatly warped because of the flexibility and cure shrinkage of the conventional curable overcoating agents, and downsized, lightweight and thinner flexible boards cannot meet required properties.

JP-A-2004-137370 (Patent Document 2) discloses polyamideimide resins from the reaction of a urethane resin having diisocyanate-terminated ends with trimellitic acid wherein the diisocyanate-terminated urethane resin is obtained by reacting a polycarbonate diol from a diol of 6 or less carbon atoms and a diisocyanate compound. However, cured products of the resins have insufficient long-term reliability of electric characteristics.

If an overcoating agent has low adhesion to a substrate, the protective layer may easily separate from the substrate upon impact or the like. Therefore, improvements are required so that protective layers show high bond strength to substrates. In particular, it is sometimes the case with recent flexible circuit boards that a wiring pattern is plated with tin and thereafter an overcoating agent is applied to the tin plating layer to form a surface protective layer. Accordingly, the surface protective layer should have high bond strength to the tin plating layer.

However, the study of adhesion of the conventional overcoating agents has been directed to metals that form a wiring pattern such as copper, and has not been carried out in depth for wiring patterns having a tin plating layer.

Patent Document 1: JP-A-2006-36801

Patent Document 2: JP-A-2004-137370

### DISCLOSURE OF THE INVENTION

### PROBLEM TO BE SOLVED BY THE INVENTION

It is an object of the present invention that a flexible circuit board overcoating agent forms a surface protective layer that shows good bond strength with metals forming a wiring pattern on a flexible circuit board and with the flexible circuit board, shows high long-term reliability of electric insulation, and has small warpage due to cure shrinkage. It is another object that a surface protective layer is provided by curing the overcoating agent, and a thermosetting resin composition that forms the overcoating agent is provided.

### MEANS TO SOLVE THE PROBLEM

A thermosetting resin composition according to the present invention comprises a carboxyl group-containing urethane resin (A), a curing agent (B) and an acid anhydride (C) as essential components. In the invention, the acid anhydride (C) is preferably a compound having two or more acid anhydride groups in the molecule, or a compound

having one or more acid anhydride groups and one or more carboxyl groups in the molecule.

The carboxyl group-containing urethane resin (A) is preferably obtained by reacting:

(a) a polyisocyanate compound,
(b) a polyol compound,
(c) a carboxyl group-containing dihydroxy compound, and optionally
(d) a monohydroxy compound and/or (e) a monoisocyanate compound.

The carboxyl group-containing urethane resin (A) generally has a number-average molecular weight of 500 to 50000.

The polyol compound (b) is preferably a polycarbonate diol and/or a polybutadiene diol. In particular, the polycarbonate diol preferably has a C8-18 alkylene group in its skeleton and a hydroxyl group at both ends.

The thermosetting resin composition may contain an inorganic filler and/or an organic filler. The inorganic fillers preferably include at least one filler selected from the group consisting of silica, talc, barium sulfate, calcium carbonate, aluminum hydroxide, aluminum oxide, magnesium hydroxide, magnesium oxide and mica. The organic fillers preferably include at least one filler selected from the group consisting of silicone resin fillers, fluororesin fillers and polybutadiene resin fillers.

A flexible circuit board overcoating agent according to the present invention comprises the thermosetting resin composition.

A surface protective layer according to the present invention comprises a cured product of the thermosetting resin composition.

The thermosetting resin compositions have excellent adhesion to a tin plating layer formed over the surface of a wiring pattern of a flexible circuit board, and prevent migration even when a voltage is applied to the wiring pattern for a long time and thereby ensure that the electric resistance between wires does not change over a long period of time.

The surface protective layers formed by curing the thermosetting resin compositions have excellent flexibility and do not separate or will not be cracked or whitened even when the flexible circuit boards are folded during use. The thermosetting resin compositions of the invention have small cure shrinkage and will not cause warpage of flexible circuit boards.

## EFFECT OF THE INVENTION

The thermosetting resin compositions of the invention give protective layers that have excellent adhesion to substrates and in particular to tin, excellent long-term reliability of electric insulation and small warpage.

In particular, the thermosetting resin compositions, which contain the carboxyl group-containing urethane resin (A), the curing agent (B) and the acid anhydride (C), show high adhesion to both flexible boards composed of polyimide films and the like, and wiring patterns on the boards that are coated with a tin-plating layer. The surface protective layers from the thermosetting resin compositions are highly flexible and can follow the change in shape of flexible boards without separating or whitening.

## BEST MODE FOR CARRYING OUT THE INVENTION

The thermosetting resin compositions, flexible circuit board overcoating agents, and surface protective layers of the invention will be described in detail hereinbelow.

A thermosetting resin composition according to the present invention contains a carboxyl group-containing urethane resin (A), a curing agent (B) and an acid anhydride (C) as essential components.

### (A) Carboxyl group-containing urethane resin

The carboxyl group-containing urethane resin (A) in the thermosetting resin composition is basically obtained by reacting:

(a) a polyisocyanate compound,
(b) a polyol compound, and
(c) a carboxyl group-containing dihydroxy compound.

The polyol compound (b) used in the production of the carboxyl group-containing urethane resin (A) may be:

(b-1) a polycarbonate diol and/or

(b-2) a polybutadiene diol (b-2-1), a diol with silicone at both ends (b-2-2), or a diol with silicone at one end (b-2-3).

The carboxyl group-containing urethane resins (A) include carboxyl group-containing urethane resins (A-1) and carboxyl group-containing urethane resins (A-2) as described below.

The carboxyl group-containing urethane resins (A-1) are obtained by reacting:

(a) a polyisocyanate compound;
(b-1) a polycarbonate diol having:

(i) a number-average molecular weight of 500 to 50,000,
(ii) a C8-18 alkylene group in its skeleton, and
(iii) a hydroxyl group at both ends;

(c) a carboxyl group-containing dihydroxy compound; and optionally
(d) a monohydroxy compound and/or (e) a monoisocyanate compound.

The carboxyl group-containing urethane resins (A-2) are obtained by reacting:

(a) a polyisocyanate compound;
(b-2) a polybutadiene diol (b-2-1), a diol with silicone at both ends (b-2-2), or a diol with silicone at one end (b-2-3) having:

(i) a number-average molecular weight of 500 to 50,000, and
(ii) a hydroxyl group at both ends;

(c) a carboxyl group-containing dihydroxy compound; and optionally
(d) a monohydroxy compound and/or (e) a monoisocyanate compound.
The polyisocyanate compounds (a) used in the synthesis of the carboxyl group-containing urethane resins (A) are mainly diisocyanate compounds as described below.

<u>(a) Polyisocyanate compounds</u>

Examples of the polyisocyanate compounds (a) used in the synthesis of the carboxyl group-containing urethane resins (A) include diisocyanates such as:

2,4-tolylene diisocyanate, 2,6-tolylene diisocyanate, isophorone diisocyanate, 1,6-hexamethylene diisocyanate, 1,3-trimethylene diisocyanate, 1,4-tetramethylene diisocyanate, 2,2,4-trimethylhexamethylene diisocyanate, 2,4,4-trimethylhexamethylene diisocyanate, 1,9-nonamethylene diisocyanate, 1,10-decamethylene diisocyanate, 1,4-cyclohexane diisocyanate, 2,2'-diethyl ether diisocyanate, diphenylmethane-4,4'-diisocyanate, (o, m or p)-xylene diisocyanate, methylenebis(cyclohexyl isocyanate), cyclohexane-1,3-dimethylene diisocyanate, cyclohexane-1,4-dimethylene diisocyanate, 1,5-naphthalene diisocyanate, p-phenylene diisocyanate, 3,3'-methyleneditolylene-4,4'-diisocyanate, 4,4'-diphenyl ether diisocyanate, tetrachlorophenylene diisocyanate, norbornane diisocyanate and hydrogenated (1, 3- or 1, 4-) xylylene diisocyanate.

The diisocyanates may be used singly or in combination.

The polyisocyanate compounds (a) described above are diisocyanate compounds having two isocyanate groups in the molecule. In the invention, polyisocyanates having three or more isocyanate groups such as triphenylmethane triisocyanate may be used in small amounts as long as the carboxyl group-containing urethane resin (A) is not gelled.

Preferred polyisocyanate compounds (a) used in the invention are alicyclic compounds or aromatic compounds having 6 to 30 carbon atoms other than the carbon atoms in the isocyanate groups (NCO). When such polyisocyanate compounds are used, the obtainable thermosetting resin composition gives cured products such as surface protective layers that have improved long-term insulation reliability at high temperature and high humidity.

The alicyclic compounds or aromatic compounds generally account for not less than 10 mol%, preferably 20 mol%, and more preferably not less than 30 mol% of the total (100 mol%) of the polyisocyanate compounds (a) used.

Examples of the alicyclic compounds and aromatic compounds include 1, 4-cyclohexane diisocyanate, isophorone diisocyanate, methylenebis(4-cyclohexyl isocyanate), cyclohexane-1,3-dimethylene diisocyanate, cyclohexane-1,4-dimethylene diisocyanate, hydrogenated (1,3-or 1,4-)xylylene diisocyanate, 2,4-tolylene diisocyanate, 2,6-tolylene

diisocyanate and diphenylmethane-4,4'-diisocyanate.

(b) Polycarbonate diols

The polyol compound (b) used in the production of the carboxyl group-containing urethane resin (A) may be a polycarbonate diol (b-1) having a number-average molecular weight of 500 to 50,000, a C8-18 alkylene group ($-C_nH_{2n}-$) in its skeleton, and a hydroxyl group at both ends.

Here, the number-average molecular weight is measured by gel permeation chromatography (GPC) relative to polystyrene standards under conditions that will be described later.

The polycarbonate diols (b-1) that are polydiols (b) may be prepared by ester exchange between a raw material C8-18 diol (hereinafter also referred to as the raw material diol) and a carbonate, or by dehydrochlorination of the raw material diol and phosgene.

The polycarbonate diols (b-1) may be represented by Formula (1) below.

[Chem. 1]

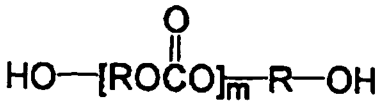

(1)

In Formula (1), R is a residue of the raw material diol HO-R-OH after the removal of the OH groups, the plurality of R may be the same or different from each other, and the letter m is a positive integer.

The raw material diols may include other than the diols of 8 to 18 carbon atoms, such as diols of 7 or less carbon atoms, diols of 19 or more carbon atoms, polyether polyols, polybutadienes terminated with a hydroxyl group at both ends, and polyester polyols, while still achieving the objects of the invention.

For use in the production of the polycarbonate diols (b-1) by ester exchange, examples of the carbonates as raw materials include dialkyl carbonates such as dimethyl carbonate and diethyl carbonate; diaryl carbonates such as diphenyl carbonate; and alkylene carbonates such as ethylene carbonate and propylene carbonate.

The raw material diol and the carbonate may be subjected to ester exchange at 100 to 230°C to give a polycarbonate diol (b-1). The ester exchange may be performed at atmospheric pressure or an appropriate reduced pressure depending on the progress of the reaction.

The ester exchange may take place without catalysts, but may be catalyzed for accelerated reaction.

The catalysts for use in the ester exchange may be conventional ester exchange catalysts used in the polycarbonate production. Examples of the ester exchange catalysts include titanium compounds such as tetraisopropoxytitanium and tetra-n-butoxytitanium; tin compounds such as di-n-butyltin dilaurate, di-n-butyltin oxide and dibutyltin diacetate; and combinations of metal acetates such as magnesium acetate, calcium acetate and zinc acetate with antimony oxide or the above titanium compounds. The catalysts may be used in amounts such that the content thereof relative to the product will be 1 to 300 ppm.

In a preferred polycarbonate diol (b-1), not less than 30 mol% of R in Formula (1) (relative to the total of R being 100 mol%) is preferably accounted for by a C8-18 alkylene group. Such polycarbonate diols may be produced using raw material diols including not less than 30 mol% of a C8-18 diol relative to the total of the raw material diols.

Examples of such polycarbonate diols (b-1) include polycarbonate diols that have skeletons containing alkylene groups such as $-(CH_2)_9-$, $-CH_2-CH(CH_3)-(CH_2)_6-$, $-(CH_2)_8-$, $-(CH_2)_{10}-$ and $-CH((CH_2)_{11}CH_3)-CH_2-$. These polycarbonate diols may be produced using 1,9-nonane diol, 2-methyl-1,8-octane diol, 1,8-octane diol, 1, 10-decamethylene glycol and 1,2-tetradecane diol, respectively, as raw material diols.

The polycarbonate diol (b-1) may contain plural kinds of alkylene groups in its skeleton (i.e., copolymerized polycarbonate diol). Examples of such diols that are commercially available include KURARAY POLYOL C-1015N, KURARAY POLYOL C-1065N, KURARAY POLYOL C-2015N and KURARAY POLYOL C-2065N (manufactured by KURARAY CO., LTD.).

In view of the solubility in solvents for the carboxyl group-containing urethane resin (A), the polycarbonate diol (b-1) preferably has a branched skeleton. Examples of such polycarbonate diols include copolymerized polycarbonate diols with skeletons that have the alkylene groups represented by $-(CH_2)_9-$ (hereinafter also referred to as the 1,9-

nonanediol skeleton) and $-CH_2-CH(CH_3)-(CH_2)_6-$ (hereinafter also referred to as the 2-methyl-1,8-octane skeleton).

In a preferable copolymerized polycarbonate diol, not less than 5 mol%, preferably not less than 10 mol%, and more preferably not less than 15 mol% of R in Formula (1) (relative to the total of R being 100 mol%) is accounted for by the 2-methyl-1,8-octane skeleton.

If the polycarbonate diol (b-1) has an excessively low molecular weight, the obtainable thermosetting resin composition may not give cured products having desired properties. If the molecular weight is excessively high, a solution of the carboxyl group-containing urethane resin (A) may not achieve expected properties; for example, the urethane resin may show low solubility in the solvent, or the solution may have an excessively high viscosity. Accordingly, the number-average molecular weight of the polycarbonate diol (b-1) is preferably in the range of 500 to 5,000, and more preferably 1,000 to 4,000.

The polycarbonate diol (b-1) may be used in combination with polycarbonate diols from diols of 7 or less carbon atoms, polybutadiene diols, polyether polyols, polyester polyols and low-molecular weight diols (other than the compounds (c)) in order to control the solubility of the carboxyl group-containing urethane resin (A) in solvents, or to improve the heat resistance of cured products from the thermosetting resin composition. The amount of such components will be 5 to 80 parts by mass based on 100 parts by mass of the polycarbonate diols.

In the ester exchange reaction, polycarbonates with a hydroxyl group at one end may be by-produced. In the invention, the polycarbonate diols (b-1) may include such by-products as long as the amount thereof is very small, for example not more than 5% by mass.

In place of the polycarbonate diols (b-1) as the polyol compounds (b), specific polybutadiene diols (b-2) may be used.

The polybutadiene diol (b-2) is a polybutadiene diol (b-2-1), a diol with silicone at both ends (b-2-2), or a diol with silicone at one end (b-2-3) having:

(i) a number-average molecular weight of 500 to 50,000, and
(ii) a hydroxyl group at both ends.

The polybutadiene diol (b-2) is preferably butadiene that is polymerized to a number-average molecular weight of 500 to 5000, and more preferably 1000 to 4000. The polybutadiene may have a hydroxyl group at molecular ends (polybutadiene diol (b-2-1)). The hydroxyl groups at the molecular ends of the polybutadiene diol (b-2-1) may be substituted with silicone having a hydroxyl group (diol with silicone at both ends (b-2-2)), or one of the hydroxyl groups at the molecular ends of the polybutadiene diol (b-2-1) may be substituted with silicone having a hydroxyl group (diol with silicone at one end (b-2-3)).

Here, the number-average molecular weight is measured relative to polystyrene standards by a method that will be described later.

(c) Carboxyl group-containing dihydroxy compounds

Examples of the carboxyl group-containing dihydroxy compounds (c) include 2,2-dimethylolpropionic acid, 2,2-dimethylolbutanoic acid, N,N-bishydroxyethylglycine and N,N-bishydroxyethylalanine. Of these, 2,2-dimethylolpropionic acid and 2,2-dimethylolbutanoic acid are particularly preferred because of solubility in solvents. The carboxyl group-containing dihydroxy compounds may be used singly or in combination. The carboxyl group-containing dihydroxy compounds (c) introduce the carboxyl groups in the obtainable urethane resin.

(d) Monohydroxy compounds and (e) monoisocyanate compounds

The carboxyl group-containing urethane resins of the invention may be synthesized using the above-described three components (the components (a), (b) and (c)). In addition, a monohydroxy compound (d) and/or a monoisocyanate compound (e) may be used in the reaction in order for the obtainable carboxyl group-containing urethane resin to have radical polymerizability or cationic polymerizability or in order to reduce the influence of the terminal isocyanate residues or hydroxyl groups of the obtainable carboxyl group-containing urethane resin.

The monohydroxy compounds (d) that are used to give the carboxyl group-containing urethane resin radical polymerizability or cationic polymerizability may be hydroxyl group-containing compounds that have a radically polymerizable double bond. Examples of such monohydroxy compounds (d) include 2-hydroxyethyl (meth)acrylate, hydroxypropyl (meth)acrylate, hydroxybutyl (meth)acrylate, cyclohexanedimethanol mono(meth)acrylate, adducts of these (meth)acrylates with caprolactone or alkylene oxides, glycerin di(meth)acrylate, trimethylol di(meth)acrylate, pentaerythritol tri(meth)acrylate, dipentaerythritol penta(meth)acrylate, ditrimethylolpropane tri(meth)acrylate, allyl alcohols, and allyloxy ethanol. Examples of the monohydroxy compounds (d) further include carboxyl group-containing monohydroxy compounds such as glycolic acid and hydroxypivalic acid. The carboxyl groups may be introduced in the urethane resin

by the use of these carboxyl group-containing monohydroxy compounds too.

The monohydroxy compounds may be used singly or in combination. Of these compounds, 2-hydroxyethyl (meth)acrylate, hydroxypropyl (meth)acrylate, hydroxybutyl (meth)acrylate, allyl alcohols, glycolic acid and hydroxypivalic acid are preferred, and 2-hydroxyethyl (meth)acrylate is more preferred.

Examples of the monohydroxy compounds (d) that are used to reduce the influence of the terminal isocyanate residues of the urethane resin include the above monohydroxy compounds, and alcohols such as methanol, ethanol, n-propanol, isopropanol, n-butanol, isobutanol, sec-butanol, t-butanol, amyl alcohol, hexyl alcohol and octyl alcohol.

Examples of the monoisocyanate compounds (e) used in the production of the carboxyl group-containing urethane resin include:

monoisocyanate compounds having a radically reactive double bond such as (meth)acryloyloxyethyl isocyanate;
adducts of 2-hydroxyethyl (meth)acrylate, hydroxypropyl (meth)acrylate, hydroxybutyl (meth)acrylate and cyclohexanedimethanol mono(meth)acrylate with diisocyanate compounds;
adducts of the above-described caprolactone or alkylene oxide adducts of the (meth)acrylates with diisocyanate compounds; and
monoadducts of glycerin di(meth)acrylate, trimethylol di(meth)acrylate, pentaerythritol tri(meth)acrylate, dipentaerythritol penta(meth)acrylate, ditrimethylolpropane tri(meth)acrylate, allyl alcohols and allyloxy ethanol with diisocyanate compounds.

Examples of the monoisocyanate hydroxy compounds (d) used to reduce the influence of the terminal residual hydroxyl groups include phenyl isocyanate, hexyl isocyanate and dodecyl isocyanate.

<Carboxyl group-containing urethane resins>

The carboxyl group-containing urethane resin (A) forming the thermosetting resin composition has a number-average molecular weight of 500 to 50,000, preferably 1,000 to 50,000, and more preferably 3,000 to 50,000. Here, the number-average molecular weight is measured by gel permeation chromatography (GPC) relative to polystyrene standards. If the molecular weight is less than 500, the obtainable cured films may have poor elongation, flexibility and strength. This tendency is often seen when the molecular weight is less than 1,000. If the molecular weight exceeds 50, 000, and in particular if it exceeds 100,000, the urethane resin may show low solubility in solvents or give excessively viscous solutions, causing great restrictions in use.

In the invention, the number-average molecular weight is measured by GPC under the following conditions unless otherwise specified.

Chromatograph: HPLC unit HSS-2000 manufactured by JASCO Corporation
Column: Shodex column LF-804
Mobile phase: tetrahydrofuran
Flow rate: 1.0 ml/min
Detector: RI-2031 Plus manufactured by JASCO Corporation
Temperature: 40.0°C
Sample amount: Sample loop 100 μl
Sample concentration: approximately 0.1 wt%
The carboxyl group-containing urethane resin (A) forming the thermosetting resin composition has an acid value of 5 to 120 mgKOH/g, and preferably 10 to 70 mgKOH/g. If the acid value is less than 5 mgKOH/g, the carboxyl group-containing urethane resin (A) may reduce reactivity with other curable resins such as epoxy resins and the heat resistance may be deteriorated. If the acid value exceeds 120 mgKOH/g, the obtainable cured films may be excessively rigid and brittle.

In the invention, the acid value of the carboxyl group-containing urethane resin (A) is measured by the following method.

Approximately 0.2 g of a sample was weighed in a 100 ml conical flask with use of a precision balance and was dissolved by adding 10 ml of an ethanol/toluene (1/2 by mass) mixed solvent. To the flask, one to three drops of a phenolphthalein ethanol solution as an indicator were added. The liquid was stirred sufficiently to uniformity. The sample was titrated with a 0.1 N potassium hydroxide-ethanol solution. The neutralization point was determined when the indicator presented a light pink color for 30 seconds. The following formula was calculated using the titration data to determine the acid value of the resin.

$$\text{Acid value (mgKOH/g)} = [B \times f \times 5.611]/S$$

B: Consumption of 0.05 N potassium hydroxide-ethanol solution (ml)
f: Factor of 0. 05 N potassium hydroxide-ethanol solution
S: Amount of sample (g)

The carboxyl group-containing urethane resins (A) may be synthesized by reacting the polyisocyanate (a), the polycarbonate diol (b), the dihydroxy compound (c) and optionally the monohydroxy compound (d) and/or the monoisocyanate compound (e) in an appropriate organic solvent with or without a known urethane forming catalyst such as dibutyltin dilaurylate. The reaction without any catalysts leads to improved properties of the final cured films in actual use.

The organic solvents used in the synthesis of the carboxyl group-containing urethane resin (A) have low reactivity with isocyanates, and are preferably free of basic compounds such as amines and have a boiling point of 120°C or above, and preferably 200°C or above. Examples of the solvents include toluene, xylene, ethylbenzene, nitrobenzene, cyclohexane, isophorone, diethylene glycol dimethyl ether, ethylene glycol diethyl ether, propylene glycol methyl ether acetate, propylene glycol ethyl ether acetate, dipropylene glycol methyl ether acetate, diethylene glycol ethyl ether acetate, methyl methoxypropionate, ethyl methoxypropionate, methyl ethoxypropionate, ethyl ethoxypropionate, ethyl acetate, n-butyl acetate, isoamyl acetate, ethyl lactate, acetone, methyl ethyl ketone, cyclohexanone, N,N-dimethylformamide, N,N-dimethylacetamide, N-methylpyrrolidone, γ-butyrolactone, dimethylsulfoxide, chloroform and methylene chloride.

Of the solvents, propylene glycol methyl ether acetate, propylene glycol ethyl ether acetate, dipropylene glycol methyl ether acetate, diethylene glycol ethyl ether acetate and γ-butyrolactone are particularly preferable in view of the facts that organic solvents in which the carboxyl group-containing urethane resin shows low solubility are not desirable, and the carboxyl group-containing urethane resins (A) are used as materials for inks in electronic materials.

In the synthesis of the carboxyl group-containing urethane resin (A), the materials may be added in any order without limitation. Usually, the polycarbonate diol (b) and the dihydroxy compound (c) are dissolved in a solvent and heated to 20 to 150°C, and preferably 60 to 120°C; then the diisocyanate compound (a) is added dropwise and the reaction is carried out at 30 to 160°C, and preferably 50 to 130°C.

The molar ratio of the materials may be changed depending on the desired molecular weight and acid value of the urethane resin. When the carboxyl group-containing urethane resin (A) obtained will be further reacted with the monohydroxy compound (d), the diisocyanate compound (a) should be used in excess over the polyol compound (b) and the carboxyl group-containing dihydroxy compound (c) (so that the isocyanate groups will be excess over the hydroxyl groups) to make sure that the polyurethane molecule will be terminated with the isocyanate groups.

In detail, the molar ratio between the diisocyanate compound (a) and the total of the polyol compound (b) and the carboxyl group-containing dihydroxy compound (c) in the reaction is controlled to the range of 0.5-1.5:1, and preferably 0.8-1.2:1.

The molar ratio between the polyol compound (b) and the carboxyl group-containing dihydroxy compound (c) is controlled to the range of 1:0.1-30, and preferably 1:0.3-10.

When the monohydroxy compound (d) is used, the diisocyanate compound (a) is used in excess in terms of mole over the total of the polycarbonate diol (b) and the carboxyl group-containing dihydroxy compound (c), and the monohydroxy compound (d) is used in a molar amount 0.5 to 1.5 times, and preferably 0.8 to 1.2 times the excess moles of the NCO groups.

When the monoisocyanate compound (e) is used, the polyol compound (b) and the carboxyl group-containing dihydroxy compound (c) combined are used in excess in terms of mole over the diisocyanate compound (a), and the monoisocyanate compound is used in a molar amount 0.5 to 1.5 times, and preferably 0.8 to 1.2 times the excess moles of the hydroxyl groups.

For the monohydroxy compound (d) to be introduced in the carboxyl group-containing urethane resin, the monohydroxy compound (d) is reacted with the residual isocyanate groups at both ends of the urethane resin when the reaction of the polyol (b) and dihydroxy compound (c) with the diisocyanate compound (a) has substantially completed. For the reaction, the monohydroxy compound (d) is added dropwise to the solution of the urethane resin at 20 to 150°C, and preferably 70 to 120°C, and the reaction is allowed to complete at the temperature.

For the monoisocyanate compound (e) to be introduced in the urethane resin, the monoisocyanate compound (e) is reacted with the residual hydroxyl groups at both ends of the urethane resin when the reaction of the polydiol (b) and dihydroxy compound (c) with the diisocyanate compound (a) has substantially completed. For the reaction, the monoisocyanate compound (e) is added dropwise to the solution of the urethane resin at 20 to 150°C, and preferably 50 to 120°C, and the reaction is allowed to complete at the temperature.

The thermosetting resin composition of the invention contains a curing agent (B) to cure the carboxyl group-containing urethane resin (A).

(B) Curing agent

The curing agent (B) for the carboxyl group-containing urethane resin (A) is preferably an epoxy resin.

Examples of the epoxy resins used as the curing agents (B) include epoxy compounds having two or more epoxy groups in the molecule, such as bisphenol A epoxy resins, hydrogenated bisphenol A epoxy resins, brominated bisphenol A epoxy resins, bisphenol F epoxy resins, novolak epoxy resins, phenol novolak epoxy resins, cresol novolak epoxy resins, N-glycidyl epoxy resins, bisphenol A novolak epoxy resins, chelated epoxy resins, glyoxal epoxy resins, amino group-containing epoxy resins, rubber-modified epoxy resins, dicyclopentadiene phenolic epoxy resins, silicone-modified epoxy resins, ε-caprolactone-modified epoxy resins, glycidyl group-containing aliphatic epoxy resins, and glycidyl group-containing alicyclic epoxy resins.

The curing agent (B) may contain atoms such as halogens such as chlorine and bromine and phosphorus so that the thermosetting resin composition may give flame-retardant cured products. Examples of the curing agents (B) further include bisphenol S epoxy resins, diglycidyl phthalate resins, heterocyclic epoxy resins, bixylenol epoxy resins, biphenol epoxy resins, and tetraglycidyl xylenoyl ethane resins.

The epoxy resins used as the curing agents (B) in the invention preferably have two or more epoxy groups. But the curing agents may include epoxy resins with one epoxy group.

The curing agents (B) may be generally used in an amount of 1 to 50 parts by mass, and preferably 3 to 30 parts by mass based on 100 parts by mass of the carboxyl group-containing urethane resin (A).

(C) Acid anhydride

The thermosetting resin composition of the invention contains an acid anhydride (C).

The acid anhydrides used in the invention include aromatic acid anhydrides, aliphatic acid anhydrides and alicyclic acid anhydrides. In a preferred embodiment, the acid anhydride (C) has two or more acid anhydride groups in the molecule, or has one or more acid anhydride groups and one or more carboxyl groups in the molecule.

According to the above preferred embodiment, the obtainable thermosetting resin composition shows strong adhesion. This is probably due to the acid anhydride having in the molecule a functional group that produces high adhesion with tin and a functional group that reacts with the functional groups of the resin composition forming the protective layer.

Examples of the acid anhydrides (C) for use in the invention include:

low molecular-weight compounds such as:

pyromellitic anhydride (Formula (2) below)

[Chem. 2]

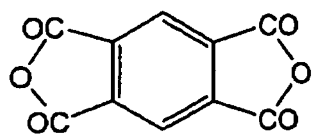

. . . (2)

trimellitic anhydride (Formula (3) below)

[Chem. 3]

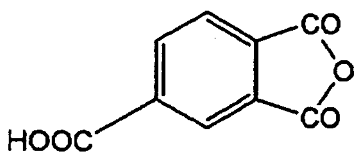

. . . (3)

3,3'-4,4'-biphenyltetracarboxylic anhydride,
4,4'-oxydiphthalic anhydride,

3,3'-4,4'-benzophenonetetracarboxylic anhydride,
3,3'-4,4'-diphenylsulfonetetracarboxylic anhydride (trade name: RIKACID DSDA manufactured by New Japan Chemical Co., Ltd.) (Formula (4) below)

[Chem. 4]

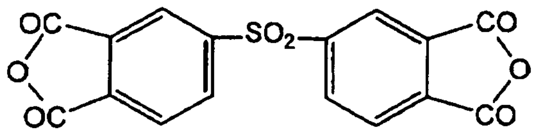

. . . (4)

4,4'-hexafluoropropylidenebisphthalic anhydride,
2,2-bis[4-(3,4-dicarboxyphenoxy)phenyl]propanoic anhydride,
naphthalene-1,8:4,5-tetracarboxylic anhydride,
acid anhydride represented by Formula (5) below (trade name: RIKACID TMEG-100 manufactured by New Japan Chemical Co., Ltd.)

[Chem. 5]

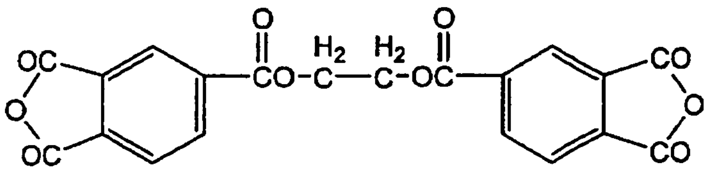

. . . (5)

and cyclohexane-1,2,3,4-tetracarboxylic acid=3,4-anhydride; and
acid anhydride-modified resins or oligomers such as ethylene maleic anhydride copolymer and methylvinyl maleic anhydride copolymer.

The acid anhydrides (C) may be used singly or in combination.

The acid anhydrides (C) may be generally used in an amount of 1 to 50 parts by mass, and preferably 3 to 30 parts by mass based on 100 parts by mass of the carboxyl group-containing urethane resin.

(D) Solvent

The thermosetting resin composition of the invention preferably contains a solvent. In a more preferred embodiment of the thermosetting resin composition, at least part of the resin component is dissolved in the solvent. In a particularly preferred embodiment, the solvent is one that is used in the synthesis of the resin, and the thermosetting resin is dissolved in the solvent. If the resin is synthesized in the form of solid and the solid resin is used in the production of the thermosetting resin composition, it is difficult to disperse the thermosetting resin without a solvent. Further, dissolving the solid resin in a solvent adds steps and is not economically favorable.

The solvent is not particularly limited as long as it can dissolve the thermosetting resin. Solvents having a boiling point of 30 to 400°C are preferable, and those having a boiling point of 100 to 300°C are particularly preferable.

Examples of the solvents used in the invention include toluene, xylene, ethylbenzene, nitrobenzene, cyclohexane, isophorone, diethylene glycol dimethyl ether, ethylene glycol diethyl ether, carbitol acetate, propylene glycol methyl ether acetate, propylene glycol ethyl ether acetate, dipropylene glycol methyl ether acetate, diethylene glycol ethyl ether acetate, methyl methoxypropionate, ethyl methoxypropionate, methyl ethoxypropionate, ethyl ethoxypropionate, ethyl acetate, n-butyl acetate, isoamyl acetate, ethyl lactate, acetone, methyl ethyl ketone, cyclohexanone, N,N-dimethylformamide, N,N-dimethylacetamide, N-methylpyrrolidone, γ-butyrolactone, dimethylsulfoxide, chloroform and methylene chloride.

The amount of the solvents is preferably such that the concentration (solid concentration) of the carboxyl group-containing urethane resin in the thermosetting resin composition is 10 to 90% by mass, and more preferably 30 to 80% by mass.

[Curing of thermosetting resin composition]

In a preferred embodiment of the curing of the thermosetting resin composition, the carboxyl group-containing urethane resin (A) and optionally the solvent (D), a curing catalyst, an anti-foaming agent and additives are kneaded together and then mixed with the curing agent (B) and the acid anhydride (C). The acid anhydride (C) may be kneaded together with the carboxyl group-containing urethane resin (A) and other components. The resultant mixture may be applied by screen printing or the like and be cured by drying and heating to give a protective layer.
Examples of the curing catalysts include curing agents and curing accelerators such as:

imidazole derivatives (such as 2MZ, 2E4MZ, $C_{11}Z$, $C_{17}Z$, 2PZ, 1B2MZ, 2MZ-CN, 2E4MZ-CN, $C_{11}Z$-CN, 2PZ-CN, 2PHZ-CN, 2MZ-CNS, 2E4MZ-CNS, 2PZ-CNS, 2MZ-AZINE, 2E4MZ-AZINE, $C_{11}Z$-AZINE, 2MA-OK, 2P4MHZ, 2PHZ and 2P4BHZ manufactured by SHIKOKU CHEMICALS CORPORATION);
guanamines such as acetoguanamine and benzoguanamine;
polyamines such as diaminodiphenylmethane, m-phenylenediamine, m-xylenediamine, diaminodiphenylsulfone, dicyandiamide, urea, urea derivatives, melamine and polybasic hydrazide;
organic acid salts and/or epoxy adducts of the above compounds;
amine complexes of boron trifluoride;
triazine-derivatives such as ethyldiamino-S-triazine, 2,4-diamino-S-triazine and 2,4-diamino-6-xylyl-S-triazine;
amines such as trimethylamine, triethanolamine, N,N-dimethyloctylamine, N-benzyldimethylamine, pyridine, N-methylmorpholine, hexa(N-methyl)melamine, 2,4,6-tris(dimethylaminophenol), tetramethylguanidine and m-aminophenol;
polyphenols such as polyvinylphenols, polyvinylphenol bromides, phenol novolaks and alkylphenol novolaks;
organic phosphines such as tributylphosphine, triphenylphosphine and tris-2-cyanoethylphosphine;
phosphonium salts such as tri-n-butyl(2,5-dihydroxyphenyl)phosphonium bromide and hexadecyltributylphosphonium chloride;
quaternary ammonium salts such as benzyltrimethylammonium chloride and phenyltributylammonium chloride;
the aforesaid polybasic acid anhydrides;
cationic photopolymerization catalysts such as diphenyliodonium tetrafluoroborate, triphenylsulfonium hexafluoroantimonate, 2,4,6-triphenylthiopyrylium hexafluorophosphate, IRGACURE 261 manufactured by CIBA GEIGY, and OPTOMER SP-170 manufactured by ADEKA CORPORATION;
styrene-maleic anhydride resin; and
equimolar reaction product of phenyl isocyanate and dimethylamine, and equimolar reaction products of dimethylamine and organic polyisocyanates such as tolylene diisocyanate and/or isophorone diisocyanate.

The thermosetting resin composition may contain known additives including inorganic fillers such as barium sulfate, talc, calcium carbonate, alumina, glass powder, quartz powder and silica; fiber reinforcing materials such as glass fibers, carbon fibers and boron nitride fibers; coloring agents such as titanium oxide, zinc oxide, carbon black, iron black, organic pigments and organic dyes; antioxidants such as hindered phenol compounds, phosphorus compounds and hindered amine compounds; and ultraviolet absorbents such as benzotriazole compounds and benzophenone compounds.
Referring to the inorganic fillers for use in the thermosetting resin composition, at least one filler may be selected from the group consisting of silica, talc, barium sulfate, calcium carbonate, aluminum hydroxide, aluminum oxide, magnesium hydroxide, magnesium oxide and mica. With respect to the organic fillers, at least one filler may be selected from the group consisting of silicone resin fillers, fluororesin fillers and polybutadiene resin fillers. The fillers may be used singly or in combination.
The fillers may be generally used in an amount of 1 to 200 parts by mass, and preferably 2 to 100 parts by mass based on 100 parts by mass of the solids in the thermosetting resin composition.
The thermosetting resin composition may contain or may be mixed with viscosity modifiers, flame retardants, antibacterial agents, antifungal agents, anti-aging agents, antistatic agents, plasticizers, lubricants and foaming agents depending on use.
These additives may be dissolved or dispersed in the composition with a mixer such as a disperser, a kneader, a three-roll mill or a bead mill.
Cured products produced according to the present invention have excellent high temperature tack properties, adhesion to substrates, small warpage, flexibility, plating resistance, plating heat resistance and long-term reliability of electric insulation.

[Examples]

The present invention will be described with Examples below without limiting the scope of the invention.

[Synthetic Example 1]

Synthesis of carboxyl group-containing urethane resin (A-1) using polycarbonate diol

A reaction vessel equipped with a stirrer, a thermometer and a condenser was charged with 70.7 g of C-1065N (polycarbonate diol manufactured by KURARAY CO., LTD., molar ratio of material diols: 1,9-nonanediol:2-methyl-1,8-octanediol = 65:35, molecular weight: 991) as polycarbonate diol (polyol component (b)), 13.5 g of 2,2-dimethylolbutanoic acid (manufactured by Nippon Kasei Chemical Company Limited) as carboxyl group-containing dihydroxy compound (c), and 128.9 g of diethylene glycol ethyl ether acetate (manufactured by DAICEL CHEMICAL INDUSTRIES, LTD.) as solvent. The materials were dissolved in the solvent at 90°C.
The temperature of the reaction liquid was lowered to 70°C, and 42.4 g of DESMODULE W (manufactured by Sumitomo Bayer Urethane Co., Ltd.) as polyisocyanate (a) was added dropwise in 30 minutes with a dropping funnel.
After the completion of the dropwise addition, reaction was carried out at 80°C for 1 hour, 90°C for 1 hour and 100°C for 2 hours. When peaks assigned to the isocyanate groups were substantially nil, 1.46 g of isobutanol (manufactured by Wako Pure Chemical Industries, Ltd.) as monohydroxy compound (e) was added dropwise, and reaction was performed at 105°C for 1.5 hours.
The resultant carboxyl group-containing urethane resin (A-1) had a number average molecular weight of 6800 and an acid value in the solid of 39.9 mgKOH/g.

[Synthetic Example 2]

Synthesis of carboxyl group-containing urethane resin (A-2) using polybutadiene diol

A reaction vessel equipped with a stirrer, a thermometer and a condenser was charged with 646.5 g of G-1000 (manufactured by NIPPON SODA CO., LTD.) as polybutadiene diol (polyol component (b)), 103.8 g of 2,2-dimethylolbutanoic acid (manufactured by Nippon Kasei Chemical Company Limited) as carboxyl group-containing dihydroxy compound (c), and 989.5 g of diethylene glycol ethyl ether acetate (manufactured by DAICEL CHEMICAL INDUSTRIES, LTD.) as solvent. The materials were dissolved in the solvent at 90°C.
The temperature of the reaction liquid was lowered to 70°C, and 217.3 g of TAKENATE 600 (manufactured by MITSUI TAKEDA CHEMICALS, INC.) as polyisocyanate (a) was added dropwise in 30 minutes with a dropping funnel.
After the completion of the dropwise addition, reaction was carried out at 80°C for 1 hour, 90°C for 1 hour and 100°C for 1.5 hours. When peaks assigned to the isocyanate groups were substantially nil, 20.7 g of isobutanol (manufactured by Wako Pure Chemical Industries, Ltd.) as monohydroxy compound (e) was added dropwise, and reaction was performed at 110°C for 2 hours.
The resultant carboxyl group-containing urethane resin (A-2) had a number average molecular weight of 11500 and an acid value in the solid of 39.7 mgKOH/g.

[Evaluation as overcoating thermosetting compositions]

<Preparation of thermosetting resin compositions>

[Example 1]

A composition contained 90 g of the reaction liquid of the carboxyl group-containing urethane resin (A-1) from Synthetic Example 1 (solid concentration: 50% by mass), 10 g of the reaction liquid of the carboxyl group-containing urethane resin (A-2) from Synthetic Example 2 (solid concentration: 50% by mass), 1% by mass based on 100% by mass of the solids in the carboxyl group-containing urethane resins (A-1) and (A-2) of melamine as curing catalyst, and 0.75% by mass based on 100% by mass of the solids in the carboxyl group-containing urethane resins (A-1) and (A-2) of BYK-051 (manufactured by BYK Japan KK) as anti-foaming agent. The composition was kneaded by being passed through a three-roll mill (RIII-1 RM-2 manufactured by Kodaira Seisakusho Co., Ltd.) three times. An epoxy resin (EPIKOTE 834 manufactured by Japan Epoxy Resins Co., Ltd.) was added such that the equivalent weight of the epoxy groups was 1.1 equivalent weights relative to that of the carboxyl groups in the carboxyl group-containing urethane resins (A-1) and (A-2). Further, 1.4 g in terms of solid of pyromellitic anhydride (manufactured by MITSUBISHI GAS CHEMICAL COMPANY, INC.) as acid anhydride (C) diluted to 10% by mass with γ-butyrolactone was added. A thermosetting resin

composition was thus prepared.

[Example 2]

A thermosetting resin composition was prepared in the same manner as in Example 1 except that the amount of trimellitic anhydride (manufactured by MITSUBISHI GAS CHEMICAL COMPANY, INC.) as acid anhydride (C) in Example 1 was changed to 2.5 g (in terms of solid).

[Example 3]

A composition contained 90 g of the reaction liquid of the carboxyl group-containing urethane resin (A-1) from Synthetic Example 1 (solid concentration: 50% by mass), 10 g of the reaction liquid of the carboxyl group-containing urethane resin (A-2) from Synthetic Example 2 (solid concentration: 50% by mass), 1% by mass based on 100% by mass of the solids in the carboxyl group-containing urethane resins (A-1) and (A-2) of melamine as curing catalyst, and 0.75% by mass based on 100% by mass of the solids in the carboxyl group-containing urethane resins (A-1) and (A-2) of BYK-051 (manufactured by BYK Japan KK) as anti-foaming agent. To the composition, 2.5 g in terms of solid of diphenylsulfonetetracarboxylic dianhydride (RIKACID DSDA manufactured by New Japan Chemical Co., Ltd.) as acid anhydride (C) was added. The mixture was kneaded by being passed through a three-roll mill (RIII-1 RM-2 manufactured by Kodaira Seisakusho Co., Ltd.) three times. An epoxy resin (EPIKOTE 834 manufactured by Japan Epoxy Resins Co., Ltd.) was added such that the equivalent weight of the epoxy groups was 1.1 equivalent weights relative to that of the carboxyl groups in the carboxyl group-containing urethane resins (A-1) and (A-2). A thermosetting resin composition was thus prepared.

[Example 4]

A thermosetting resin composition was prepared in the same manner as in Example 3 except that RIKACID DSDA used as acid anhydride (C) in Example 3 was replaced by the same amount of RIKACID TMEG-100 (manufactured by New Japan Chemical Co., Ltd.) with a structure represented by Formula (5) below:
[Chem. 6]

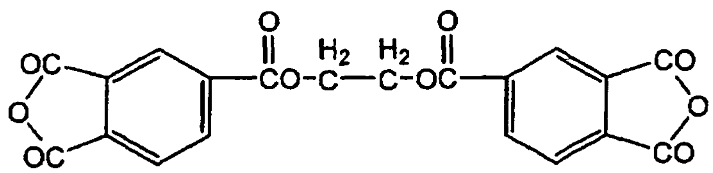

. . . (5)

[Comparative Example 1]

A thermosetting resin composition was prepared in the same manner as in Example 1 except that the acid anhydride (C) in Example 1 was not used.

<Evaluation of cured products>

The thermosetting resin compositions obtained as described above were tested as overcoating agents for flexible circuit boards. The compositions were applied and cured to give surface protective layers. The surface protective layers were evaluated for adhesion, warpage, flexibility and long-term reliability. The results are shown in Table 1.

<u>[Adhesion with tin plating layer]</u>

[Preparation of tin-plated plate]

A copper base plate (S'PERFLEX/NT-L50 manufactured by SUMITOMO METAL MINING CO., LTD.) was soaked in a 100 ml/L aqueous solution (30°C) of IPC Clean 91 (manufactured by OKUNO CHEMICAL INDUSTRIES

CO., LTD.) for 1 minute and was subsequently soaked in a 10% by mass aqueous $H_2SO_4$ solution (23°C) for 1 minute. Thereafter, the plate was soaked in an electroless Sn plating solution (LT-34 manufactured by Rohm and Haas Company) at 65°C for 4 minutes and was subsequently soaked in ion exchange water at 70°C for 3 minutes. The plate was dried at 120°C for 90 minutes with a circulating hot air drier. A tin-plated plate was thus obtained.

[Preparation of adhesion testing sample]

The thermosetting resin composition was applied on the tin-plated plate by screen printing with a 250 mesh polyester printing plate and was dried at 80°C for 30 minutes. The coating was heated in an air atmosphere at 120°C for 1 hour and at 150°C for 2 hours to give a sample having a coating thickness of 10 to 15 μm.

[Procedures of adhesion testing]

An ACF tape (CP9420IS manufactured by Sony Chemicals) 2 mm in width and approximately 30 mm in length was temporarily compression bonded to the center of a 20 x 110 mm green epoxy substrate with use of ACF thermocompression bonding apparatus PHC-500 (manufactured by Seiwa Seisakusho KK) at 120°C and 100 N for 3 seconds. The release paper of the temporarily bonded ACF tape was removed. The sample cut to the same size as the green epoxy substrate was compression bonded at 230°C and 200 N for 16 seconds, with the cured layer being in contact with the ACF tape. The green epoxy substrate and the sample compression bonded via the ACF tape were mounted on a tensile tester having a printed circuit 90° peeling jig (TENSILON/UTM-III-500 manufactured by TOYO BALOWIN CO., LTD.) such that the green epoxy substrate was on the side of the guide roller and the sample was on the side of the chuck. The peeling strength (Kgf) was measured at a rate of 50 mm/min. The width (mm) in which the resin composition of the sample was torn during the test was measured. The 90° peeling intensity (N/m) was calculated from the following equation:

$$90^\circ \text{ peeling intensity (N/m)} = \{[\text{peeling strength (Kgf)}]/[\text{width (mm)}]\} \times 9.8$$

[Warpage]

The thermosetting resin composition was applied on a 38 μm thick polyimide film [KAPTON (registered trademark) 150EN-F manufactured by DU PONT-TORAY CO., LTD.] by screen printing with a 100 mesh polyester printing plate. The printed film was dried at 80°C for 30 minutes and was thermally cured at 120°C for 1 hour and at 150°C for 2 hours. The heat-cured film was cut to a circular shape with 50 mm diameter and was placed with the printed surface upward. The warpage was evaluated based on the following criteria.

AA: The maximum warpage was less than 5 mm high.

CC: The maximum warpage was 5 mm high or more.

[Flexibility]

The thermosetting resin composition was applied on a 38 μm thick polyimide film [KAPTON (registered trademark) 150EN-F manufactured by DU PONT-TORAY CO., LTD.] by screen printing with a 100 mesh polyester printing plate. The composition was dried at 80°C for 30 minutes and was thermally cured at 120°C for 1 hour and at 150°C for 2 hours. The polyimide film coated with the heat-cured resin composition was folded 180° with the coated surface outward. The presence or absence of the whitening in the cured layer was determined. The flexibility was evaluated based on the following criteria.

AA: The cured layer was not whitened.
CC: The cured layer was whitened or cracked.

[Long-term reliability of electric insulation]

The thermosetting resin composition was applied on a comb-shaped pattern of TEST PATTERN N08 (manufactured by Nippon Polytech Corp.) (L (line)/S (space) =50μm/50 μm, comb: 32 teeth (16 teeth on the positive side, 16 teeth on the negative side), comb length: 10 mm, clearance at electrical connection (center): 35 mm) by screen printing

with a 100 mesh polyester printing plate. The composition was dried at 80°C for 30 minutes and was thermally cured at 120°C for 1 hour and at 150°C for 2 hours. The board was energized by applying a bias voltage of 100 V at 120°C and 85% RH for 200 hours, and electric insulating properties were evaluated based on the following criteria.

AA: The insulation resistance value was stable without migration.

CC: Migration occurred or the insulation resistance value was unstable in less than 200 hours.

Here, the words "the insulation resistance value was unstable" mean that the insulation resistance value lowered and caused disturbances in waveshapes during the recording of changes in insulation resistance value with time.

[Table 1]

| Adhesion with tin | | | | | |
|---|---|---|---|---|---|
| | Acid anhydride | Adhesion strength with tin: 90° peeling intensity (N/m) | Low warpage properties | Flexibility | Long-term reliability of electric insulation |
| Ex. 1 | Pyromellitic anhydride | 1604 | AA | AA | AA |
| Ex. 2 | Trimellitic anhydride | 1471 | AA | AA | AA |
| Ex. 3 | RIKACID DSDA (diphenylsulfonetetracarboxylic dianhydride) | 1661 | AA | AA | AA |
| Ex. 4 | RIKACID TMEG-100 | 1391 | AA | AA | AA |
| Comp. Ex. 1 | None | 592 | AA | AA | AA |

INDUSTRIAL APPLICABILITY

The thermosetting resin compositions of the invention give surface protective layers that have excellent adhesion to substrates and in particular to tin, excellent long-term insulation reliability at high temperature and high humidity, and small warpage. The thermosetting resin compositions may be used as flexible circuit board overcoating thermosetting resins with excellent flexibility, or electric insulating materials such as thermosetting solder resists and interlayer insulating layers with excellent insulating properties, and may be also used in the fields of IC or SLSI encapsulating materials and multilayer structures.

By using the thermosetting resin compositions as overcoating agents for flexible circuit boards, flexible circuit boards may be produced more inexpensively than with conventional liquid polyimide inks. Although conventional surface protective layers do not usually satisfy adhesion strength with substrates and long-term reliability of electric insulation at the same time, the thermosetting resin compositions of the invention as overcoating agents for flexible circuit boards can produce protective layers having good adhesion strength and excellent long-term reliability of electric insulation.

**Claims**

**1.** A thermosetting resin composition comprising a carboxyl group-containing urethane resin (A), a curing agent (B) and an acid anhydride (C) as essential components.

**2.** The thermosetting resin composition according to claim 1, wherein the acid anhydride (C) is a compound having two or more acid anhydride groups in the molecule, or a compound having one or more acid anhydride groups and one or more carboxyl groups in the molecule.

**3.** The thermosetting resin composition according to claim 1, wherein the carboxyl group-containing urethane resin (A) is obtained by reacting:

(a) a polyisocyanate compound,
(b) a polyol compound,
(c) a carboxyl group-containing dihydroxy compound, and optionally
(d) a monohydroxy compound and/or (e) a monoisocyanate compound.

4. The thermosetting resin composition according to claim 1 or 3, wherein the carboxyl group-containing urethane resin (A) has a number-average molecular weight of 500 to 50000.

5. The thermosetting resin composition according to claim 3, wherein the polyol compound (b) is a polycarbonate diol and/or a polybutadiene diol.

6. The thermosetting resin composition according to claim 5, wherein the polycarbonate diol has a C8-18 alkylene group in its skeleton and a hydroxyl group at both ends.

7. The thermosetting resin composition according to claim 1, wherein the carboxyl group-containing urethane resin (A) has an acid value of 5 to 120 mgKOH/g.

8. The thermosetting resin composition according to any one of claims 1 to 7, wherein the thermosetting resin composition further comprises an inorganic filler and/or an organic filler.

9. The thermosetting resin composition according to claim 8, wherein the inorganic fillers include at least one filler selected from the group consisting of silica, talc, barium sulfate, calcium carbonate, aluminum hydroxide, aluminum oxide, magnesium hydroxide, magnesium oxide and mica.

10. The thermosetting resin composition according to claim 8, wherein the organic fillers include at least one filler selected from the group consisting of silicone resin fillers, fluororesin fillers and polybutadiene resin fillers.

11. A flexible circuit board overcoating agent comprising the thermosetting resin composition of any one of claims 1 to 10.

12. A surface protective layer comprising a cured product of the thermosetting resin composition of any one of claims 1 to 10.

**INTERNATIONAL SEARCH REPORT**

International application No.
PCT/JP2007/054919

A. CLASSIFICATION OF SUBJECT MATTER
*C08G59/42*(2006.01)i, *C08K3/00*(2006.01)i, *C08L63/00*(2006.01)i, *C08L75/04*(2006.01)i, *H05K3/28*(2006.01)i

According to International Patent Classification (IPC) or to both national classification and IPC

B. FIELDS SEARCHED

Minimum documentation searched (classification system followed by classification symbols)
C08G59/00-59/72, C08L63/00-63/10, C08L75/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 10-279652 A (Toyobo Co., Ltd.), 20 October, 1998 (20.10.98), Claims; Par. No. [0011] (Family: none) | 1-12 |
| A | JP 50-72997 A (Sumitomo Chemical Co., Ltd.), 16 June, 1975 (16.06.75), Claims (Family: none) | 1-12 |
| A | WO 2004/079452 A1 (Nippon Kayaku Co., Ltd.), 16 September, 2004 (16.09.04), Claims; page 11 & US 2006/0102051 A1 & EP 1600812 A1 | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 April, 2007 (12.04.07) | 24 April, 2007 (24.04.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2007/054919

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-183401 A (Showa Denko Kabushiki Kaisha), 03 July, 2003 (03.07.03), Claims; Par. Nos. [0032], [0035] (Family: none) | 1-12 |
| P,X | JP 2006-274258 A (Showa Denko Kabushiki Kaisha), 12 October, 2006 (12.10.06), Claims; Par. Nos. [0027], [0029] & WO 2006/093355 A1 | 1-12 |
| P,X | JP 2006-124681 A (Showa Denko Kabushiki Kaisha), 18 May, 2006 (18.05.06), Claims; Par. No. [0025] & WO 2006/033439 A1 | 1-12 |

Form PCT/ISA/210 (continuation of second sheet) (April 2005)

**INTERNATIONAL SEARCH REPORT**

International application No.
PCT/JP2007/054919

The invention of claim 1 relates to "A heat curable resin composition comprising (A) a carboxyl group-containing urethane resin, (B) a curing agent, and (C) an acid anhydride". What is disclosed within the meaning of PCT Article 5, however, is only that, as described in the description, "a carboxyl group-containing urethane resin produced by reacting (a) a polyisocyanate compound, (b) a polyol compound, and (c) a carboxyl group-containing dihydroxy compound" is used as the resin (A), and an epoxy resin is used as the curing agent (B). Thus, the invention described in claim 1 is not supported within the meaning of PCT Article 6.

Therefore, this search was made based on a heat curable resin composition supported by the description and disclosed therein, namely, a heat curable resin composition comprising the above specific carboxyl group-containing urethane resin and an epoxy resin.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006036801 A
- JP 2004137370 A